(19) Europäisches Patentamt / European Patent Office / Office européen des brevets

(11) **EP 3 037 898 B1**

(12) **FASCICULE DE BREVET EUROPEEN**

(45) Date de publication et mention
de la délivrance du brevet:
**21.06.2017 Bulletin 2017/25**

(51) Int Cl.:
**G04C 3/14** *(2006.01)*    **G01D 5/241** *(2006.01)*

(21) Numéro de dépôt: **14200171.8**

(22) Date de dépôt: **23.12.2014**

(54) **APPAREIL ELECROMÉCANIQUE COMPORTANT UN DISPOSITIF DE DETECTION CAPACITIF DE LA POSITION ANGULAIRE D'UN MOBILE, ET PROCÉDÉ DE DETECTION DE LA POSITION ANGULAIRE D'UN MOBILE**

ELEKTROMECHANISCHES GERÄT, DAS EINEN KAPAZITIVEN DETEKTOR DER WINKELPOSITION EINES MOBILEN ELEMENTES UMFASST, UND VERFAHREN ZUR DETEKTION DER WINKELPOSITION EINES MOBILEN ELEMENTES

ELECTROMECHANICAL APPARATUS COMPRISING A DEVICE FOR CAPACITIVE DETECTION OF THE ANGULAR POSITION OF A MOVING ELEMENT, AND METHOD FOR DETECTING THE ANGULAR POSITION OF A MOVING ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**29.06.2016 Bulletin 2016/26**

(73) Titulaire: **ETA SA Manufacture Horlogère Suisse
2540 Grenchen (CH)**

(72) Inventeurs:
• **Klopfenstein, François
2800 Delémont (CH)**
• **Lagorgette, Pascal
2502 Bienne (CH)**
• **Schmutz, Damien
2520 La Neuveville (CH)**
• **Haenni, Raphäel
CH-1950 Sion (CH)**
• **Tardivon, Matthieu
CH-1020 Renens (CH)**

(74) Mandataire: **Goulette, Ludivine et al
ICB
Ingénieurs Conseils en Brevets SA
Faubourg de l'Hôpital 3
2001 Neuchâtel (CH)**

(56) Documents cités:
**JP-A- 2004 163 128     JP-A- 2004 233 132
US-A- 5 598 153     US-B1- 6 307 814**

• **VEZ P ET AL: "Systeme de detection et de synchronisation des aiguilles d'une montre", ACTES DU CONGRES EUROPEEN DE CHRONOMETRIE, SOCIETE SUIISE DE CHRONOMETRIE, NEUCHATEL, CH, 26 septembre 2007 (2007-09-26), pages 107-109, XP001551332, ISSN: 1023-2699**

EP 3 037 898 B1

## Description

<u>DOMAINE DE L'INVENTION</u>

La présente invention concerne en premier lieu un appareil électromécanique comportant un mobile rotatif, un moteur pas-à-pas, un circuit électronique de gestion agencé pour commander le moteur pas-à-pas, une transmission reliant le moteur pas-à-pas au mobile, et un dispositif de détection capacitif, la transmission ayant un rapport tel que le moteur pas-à-pas fasse accomplir exactement un tour complet au mobile en un nombre entier déterminé de pas-moteur, de sorte que les pas subdivisent le tour complet du mobile en ledit nombre entier de positions angulaires équidistantes les unes des autres, et le dispositif de détection capacitif comprenant un rotor solidaire en rotation du mobile, un stator, et un circuit électronique de mesure, le stator comportant une paire d'électrodes ayant une capacité, le rotor étant conformé de manière à ce que la valeur de la capacité dépende de la position angulaire du rotor, et le circuit électronique de mesure étant prévu pour générer et pour fournir au circuit électronique de gestion un signal dépendant de la valeur de la capacité. La présente invention concerne en second lieu un procédé pour déterminer la position angulaire d'un mobile faisant partie d'un appareil électromécanique comportant un dispositif de détection capacitif et qui est conforme à la définition ci-dessus.

<u>ART ANTERIEUR</u>

On connaît des appareils électromécaniques qui correspondent à la définition ci-dessus. On trouve notamment des exemples de tels appareils électromécaniques parmi les pièces d'horlogerie électroniques à affichage analogique. Certaines de ces pièces d'horlogerie comportent en effet un garde-temps numérique interne en plus des aiguilles tournant au-dessus du cadran. Ce garde-temps interne est cadencé par les mêmes impulsions électriques qui commandent l'avance des aiguilles. Dans ces conditions, les aiguilles et le garde-temps avancent en principe de façon synchrone. Il est notamment connu d'utiliser un tel garde-temps interne dans des montres multifonctions où les mêmes aiguilles sont prévues pour indiquer alternativement l'heure ou une deuxième information, comme par exemple une heure de réveil. En effet, un garde-temps interne est nécessaire si l'on veut pouvoir continuer à compter le temps écoulé pendant que les aiguilles sont occupées par l'affichage de la deuxième information. Lorsque les aiguilles reviennent ensuite à leur fonction d'affichage de l'heure, les informations contenues dans le garde-temps interne leurs permettent de se remettre correctement à l'heure.

Toutefois, si l'on veut qu'une application comme celle qui vient d'être mentionnée donne satisfaction, il faut être en mesure d'empêcher l'apparition d'un éventuel décalage entre l'heure affichée par les aiguilles de la montre et l'heure donnée par le garde-temps interne. Or, on sait qu'un tel décalage peut se produire par exemple si la montre subit un choc ou en raison d'une perturbation électromagnétique ou même mécanique (poussières dans le rouage par exemple). En raison de ces perturbations les moteurs de certaines pièces d'horlogerie perdent des pas. Toute pièce d'horlogerie analogique à quartz est donc susceptible de présenter un décalage entre le comptage des impulsions de commande et la position angulaire des aiguilles. Si ce décalage n'est pas corrigé à temps, il peut s'accroître au point de conduire à des indications totalement erronées.

D'autre part, dans les pièces d'horlogerie multifonctions, les aiguilles doivent pouvoir se déplacer non seulement en avant, mais également en arrière, selon les variations de la grandeur à indiquer. De plus, les aiguilles d'une pièce d'horlogerie multifonction doivent être capables de changer rapidement de position vers l'avant, ou vers l'arrière, lors d'un changement de fonction. Pour répondre à ces contraintes, les aiguilles des pièces d'horlogerie multifonctions sont, en général, entraînées chacune par son propre moteur. En conséquence, au lieu de l'unique garde-temps interne décrit plus haut, les pièces d'horlogerie multifonctions comportent habituellement un circuit de comptage/décomptage des impulsions de commande du moteur de chaque aiguille. On comprendra d'autre part que les moteurs d'une pièce d'horlogerie multifonction doivent répondre à des sollicitations considérablement plus importantes. Dans ces conditions, le risque de décalage, ou autrement dit de désynchronisation des aiguilles, est également nettement plus élevé pour une pièce d'horlogerie multifonction que pour une autre.

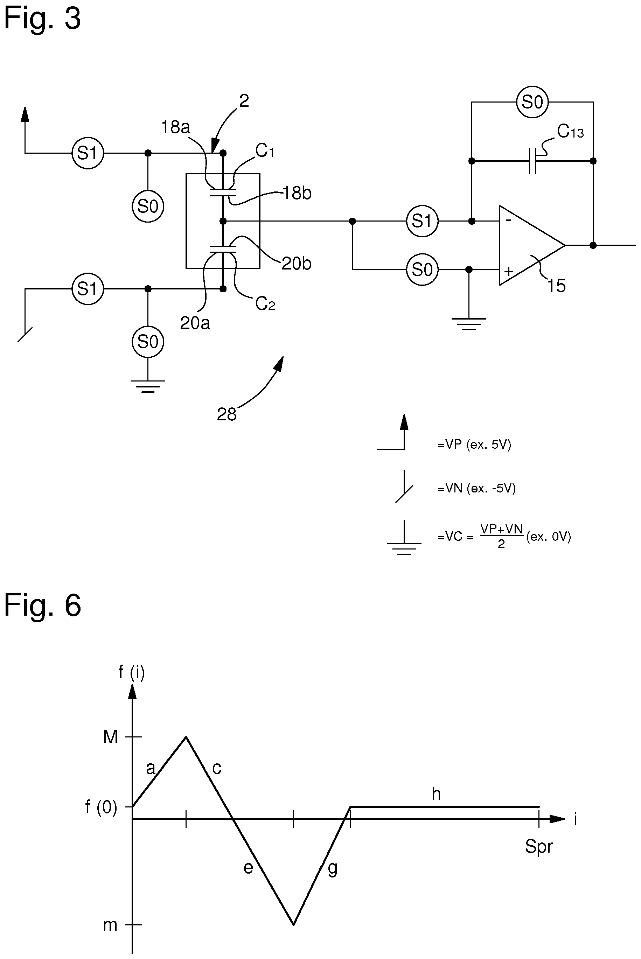

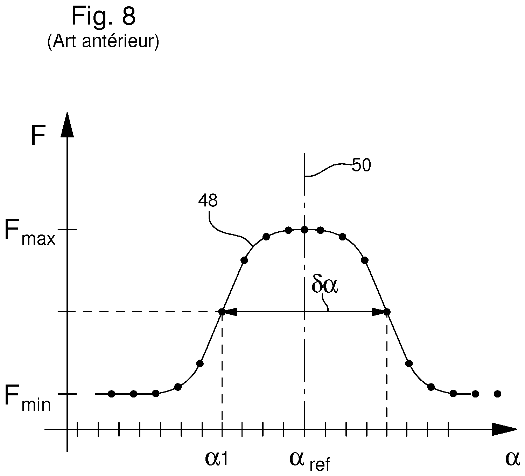

Pour remédier aux problèmes qui viennent d'être décrits, il est connu de compléter le simple comptage/décomptage des impulsions de commande des moteurs par une détection de la position réelle des aiguilles. Le document de brevet EP 0 952 426 notamment décrit une pièce d'horlogerie qui comprend un mouvement horloger pourvu d'un affichage analogique et comportant une roue solidaire en rotation d'une des aiguilles. Cette roue est constituée d'un plateau qui présente au moins une ouverture située dans la région intermédiaire entre l'axe de rotation et la circonférence. La pièce d'horlogerie comprend encore un dispositif de détection de la position angulaire de cette roue. Ce dispositif comprend un capteur inductif, ou capacitif, agencé de manière à ce qu'il se trouve directement au-dessous de l'ouverture dans le plateau lorsque la roue occupe une position angulaire de référence. Ce capteur est sensible à la variation de la quantité de métal se trouvant à proximité immédiate. La fréquence ou l'amplitude du signal détecté par le capteur, selon qu'il s'agit d'un capteur inductif ou capacitif, varie donc selon qu'il se trouve en regard d'un segment plein ou, au contraire, de l'ouverture dans le plateau de la roue, de sorte que la fréquence ou l'amplitude du signal détecté atteint une valeur extrême (qui peut être un maximum ou un minimum) lorsque l'ouverture dans le plateau passe directement en regard du capteur. Le dispositif comprend encore une mémoire pour enregistrer la fréquence ou l'amplitude du signal après chaque pas. La figure 8 annexée, qui est labellisée comme « Art antérieur », correspond à la figure 6 du document EP 0 952 426. Il s'agit d'un graphe de la fréquence du signal détecté par un capteur inductif au cours de l'avance pas-à-pas de la roue. Le document antérieur susmentionné enseigne que, pour déterminer la position angulaire de la roue à partir des informations figurant sur ce graphe, il faut se fixer une position angulaire de référence. Cette position de référence peut être la position dans laquelle l'ouverture du plateau se trouve directement en regard du capteur, de sorte que la position de référence corresponde à un pic sur le graphe. La pièce d'horlogerie comporte des moyens électroniques qui sont prévus pour identifier le point du graphe qui correspond à la position angulaire de référence, par exemple en calculant le point milieu à mi-hauteur du pic de la figure 8. Un écart angulaire $\delta\alpha$ spécifique entre les deux points à mi-hauteur déterminés doit permettre de discriminer un secteur angulaire particulier et déduire ainsi une position angulaire de référence. Une fois la position angulaire de référence identifiée sur le graphe, il est facile de connaître l'angle correspondant à chacun des autres points du graphe simplement en comptant le nombre de pas d'angle constant qui séparent le point du graphe en question de cette position angulaire de référence.

La solution antérieure qui vient d'être décrite présente certains défauts. En particulier, l'utilisation d'un capteur inductif peut s'avérer trop couteuse en énergie. D'autre part, les capteurs capacitifs présentent l'inconvénient d'être particulièrement sensibles à l'environnement et aux perturbations engendrées par les tolérances de fabrication et de montage. D'autre part, comme on l'a vu, le procédé de détection de la position angulaire divulgué dans le document de brevet susmentionné est basé sur l'identification d'une position angulaire de référence associée à une valeur extrême d'un signal détecté, or un inconvénient des capteurs capacitifs est que l'ébat de hauteur de la roue dont on veut détecter la position angulaire peut parfois avoir un effet plus grand sur le signal que la variation provoquée par le passage de l'ouverture au-dessus du capteur. Dans ces conditions, le procédé de détection divulgué dans EP 0 952 426 risque de ne pas être fiable. Ainsi, dans le but de distinguer le véritable signal des perturbations, le document antérieur susmentionné propose encore de choisir comme position angulaire de référence une position de part et d'autre de laquelle la forme du signal, en l'absence de perturbation, obéit à certaines hypothèses de symétrie. On comprendra toutefois que de telles hypothèses concernant la forme du signal impliquent des contraintes strictes concernant la forme de l'ouverture dans le plateau de la roue et/ou la géométrie des électrodes du capteur.

Dans un souci d'exhaustivité, on mentionne également les documents US6307814, JP2004163128 et JP2004233132, qui représentent de l'art antérieur pertinent par rapport à la présente invention.

BREF EXPOSE DE L'INVENTION

Un but de la présente invention est de remédier aux problèmes de l'art antérieur qui viennent d'être exposés. La présente invention atteint ce but en fournissant, d'une part, un appareil électromécanique conforme à la revendication 1 annexée, et d'autre part, un procédé de détection de la position angulaire d'un mobile du dit appareil électromécanique, qui est conforme à la revendication 12 annexée.

On comprendra que le terme « rotor » est utilisé ici pour désigner la partie en rotation d'un dispositif électromécanique (le dispositif de détection capacitif en l'occurrence) qui interagit électriquement ou magnétiquement avec une partie fixe du dispositif appelée le « stator ».

Conformément à l'invention, le stator comporte une première paire d'électrodes ayant première capacité variable en fonction de la position angulaire du rotor et une deuxième paire d'électrodes ayant une deuxième capacité variable en fonction de la position angulaire du rotor. De plus, le signal fourni par le circuit électronique de mesure est représentatif d'une différence entre les valeurs respectives de la première et de la deuxième capacité. On comprendra donc que, grâce à l'utilisation d'une mesure différentielle, notamment pour des premières et deuxièmes capacités isométriques, c'est-à-dire de valeurs égales en norme pour une influence identique du rotor, le dispositif de détection capacitif est capable de neutraliser la plus grande partie des effets parasites liés à l'environnement et aux tolérances de fabrication et de montage. En particulier, la mesure différentielle permet de neutraliser presque totalement les perturbations liées à l'ébat en hauteur du rotor.

Conformément à l'invention, la succession des pas du moteur pas-à-pas détermine un nombre entier de positions angulaires distinctes que peut occuper le mobile dont on cherche à connaître la position. La position angulaire du mobile peut donc être considérée comme un variable discrète. De plus, l'amplitude du signal généré est fourni en sortie par le circuit électronique de mesure peut être considérée comme une fonction de cette variable discrète. D'autre part, en raison de l'existence des effets parasites déjà mentionnés, l'amplitude du signal fourni par le circuit électronique de mesure lors de deux passages successifs du mobile par la même position angulaire peut changer. On comprendra donc que, bien que les positions angulaires occupées à chaque tour par le mobile soient toujours les mêmes, l'amplitude du signal qui est réellement fourni par le circuit électronique de mesure ne peut pas être considéré comme une fonction périodique de la position angulaire.

Selon l'invention, une table enregistrée dans le circuit électronique de gestion fait correspondre une pluralité de positions angulaires distinctes du mobile avec des valeurs de référence du signal de sortie. Ces valeurs du signal qui sont enregistrées sont dites de référence parce qu'il s'agit de valeurs déduites de mesures effectuées lors d'une opération de calibration initiale et que l'on considère comme étant des valeurs correspondant à l'amplitude du signal fourni par le circuit électronique de mesure en l'absence de tout effet parasite. Contrairement à l'amplitude réelle du signal, qui peut varier d'une mesure à l'autre, les valeurs de référence du signal définissent une fonction périodique, et on comprendra que la longueur de la période de la fonction est égale au nombre de pas-moteur nécessaires pour faire accomplir une révolution complète au mobile. De plus, la fonction étant périodique, chaque position angulaire différente que peut occuper le mobile est associée à une phase distincte de la fonction périodique.

Une des étapes du procédé de l'invention inclut l'opération consistant à calculer autant de corrélations qu'il y a de positions angulaires possibles du mobile. Chaque corrélation étant calculée entre, d'une part, la succession des valeurs du signal de sortie réellement mesurées sur un tour, et d'autre part, la succession des valeurs de référence du signal sur un tour complet, le point de départ du dit tour étant différent pour chaque calcul de corrélation, et ce point de départ étant choisi parmi les positions angulaires possibles du mobile. On comprendra que, dans le cas où les positions angulaires possibles du mobile sont toutes des positions angulaires équidistantes les unes des autres définies par les pas-moteur, les successions de valeurs de référence du signal sur un tour complet sont constituées par toutes les permutations circulaires de la suite des valeurs référence à l'intérieur d'un intervalle long d'une période entière du signal. Une étape ultérieure du procédé de l'invention consiste à déterminer la position angulaire du rotor en identifiant, parmi l'ensemble des corrélations calculées, la corrélation dont la valeur absolue est la plus élevée. On comprendra de ce qui précède que le procédé de l'invention permet de détecter la position angulaire du rotor sans qu'il soit nécessaire d'identifier d'abord une position angulaire de référence de ce dernier.

BREVE DESCRIPTION DES FIGURES

D'autres caractéristiques et avantages de la présente invention apparaîtront à la lecture de la description qui va suivre, donnée uniquement à titre d'exemple non limitatif, et faite en référence aux dessins annexés dans lesquels :

- la figure 1 est une vue partielle en plan de dessus montrant le dispositif de détection capacitif d'un appareil électromécanique conforme à un premier mode de réalisation particulier de l'invention, le dispositif de détection capacitif comprenant un rotor constitué par une roue dentée et un stator comprenant deux paires d'électrodes ;
- la figure 2 est une vue partielle en coupe de l'appareil électromécanique de la figure 1 montrant le dispositif de détection capacitif ;
- la figure 3 est un schéma électronique d'un mode de réalisation particulier du circuit électronique de mesure du dispositif de détection capacitif de l'appareil électromécanique illustré dans les figures 1 et 2 ;
- la figure 4 est graphique montrant à titre d'exemple différentes valeurs qu'est susceptible de prendre le signal représentatif de la différence entre la première et la deuxième capacité, lorsque le mobile est entraîné par le moteur pas-à-pas de manière à effectuer un tour complet en occupant successivement une pluralité de positions angulaires mutuellement équidistantes les unes des autres;
- la figure 5 est le graphe d'une fonction linéaire par morceaux qui correspond à une variante exemplaire de modèle paramétrique;
- la figure 6 illustre graphiquement le modèle paramétrique de la figure 5 après ajustement de l'ensemble des paramètres du modèle aux valeurs prises par les points de la courbe empirique de la figure 4;
- la figure 7A est une représentation schématique du stator d'un dispositif de détection capacitif selon un deuxième mode de réalisation de l'invention;
- la figure 7B est une représentation schématique du rotor du dispositif de détection capacitif dont le stator est représenté dans la figure 7A;
- la figure 7C contient 3 graphes servant à construire un courbe des valeurs de référence pour le dispositif de détection capacitif des figures 7A et 7B;
- la figure 8 est une copie de la figure 6 du document de brevet EP 0 952 426 A1 de l'art antérieur.

DESCRIPTION DETAILLEE D'UN MODE DE REALISATION

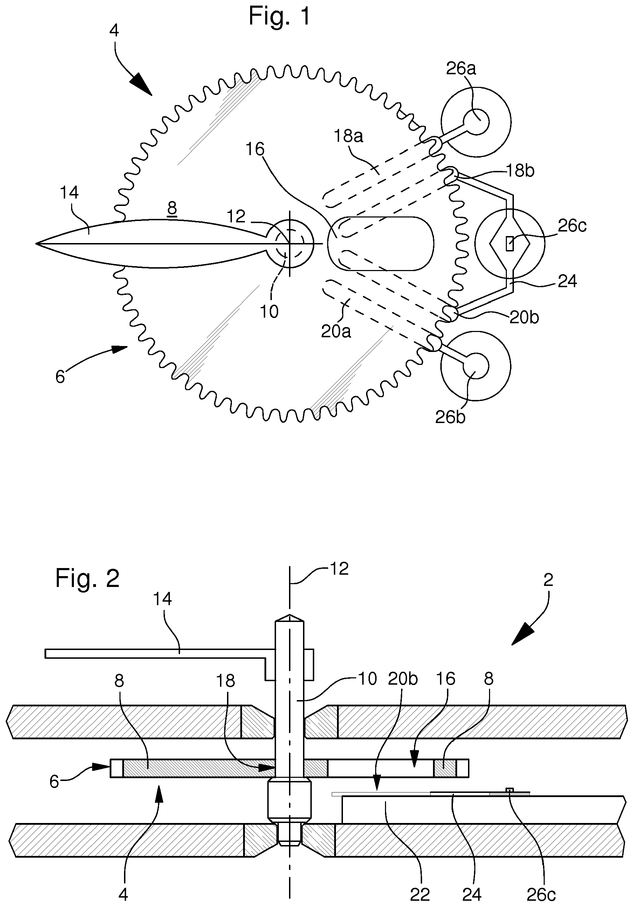

Les figures 1 et 2 sont des vues partielles, respectivement en plan de dessus et en coupe, d'un mouvement horloger à quartz correspondant à un mode de réalisation particulier de l'appareil électromécanique de l'invention. Conformément à l'invention, le mouvement horloger comporte un mobile rotatif, un moteur pas-à-pas, une transmission reliant le moteur pas-à-pas au mobile, un circuit électronique de gestion agencé pour commander le moteur pas-à-pas, et un dispositif de détection capacitif. Selon une variante avantageuse de l'invention, le circuit électronique de gestion comporte notamment un circuit de comptage des impulsions de commande du moteur pas-à-pas.

On comprendra que les figures 1 et 2 qui sont des vues partielles illustrent plus particulièrement le dispositif de détection capacitif (globalement référencé 2) et le mobile rotatif qui est constitué par une roue 4 dentée, solidaire d'un arbre 10. En se référant plus particulièrement à la figure 1, on peut voir que la roue 4 dentée comporte une planche 8 et une denture 6 entourant la planche. On peut voir également que la planche 8 est percée d'une ouverture 16. La roue 4 est solidaire de l'arbre 10 qui en définit un axe géométrique 12 de rotation. Les figures montrent également un organe indicateur analogique 14, prenant ici la forme d'une aiguille, d'un affichage analogique associé au mobile rotatif. L'aiguille est montée fixement sur l'arbre 10. Dans l'exemple illustré, l'aiguille pourrait servir à indiquer l'heure, la minute, la seconde ou toute autre information susceptible d'être indiquée par une pièce d'horlogerie. On comprendra que l'aiguille peut présenter un décalage angulaire quelconque relativement à l'ouverture 16. Toutefois, contrairement à ce que montre la figure 1, l'aiguille pointe de préférence dans la direction du centre de l'ouverture 16 de façon à ce que le balourd engendré par la présence de l'ouverture permette de compenser au moins partiellement le couple provoqué par le poids de l'aiguille. Selon un mode de réalisation alternatif non illustré, l'organe indicateur analogique 14 pourrait consister en un autre élément d'affichage tournant, comme un disque pourvu d'un curseur se déplaçant dans une fenêtre de forme annulaire aménagée dans un cadran.

Le moteur pas-à-pas (non représenté) peut être par exemple un moteur bipolaire du type « moteur Lavet ». La transmission (non représentée) est de préférence constituée par un rouage réducteur qui relie le moteur à la roue 4 dentée. Finalement, le circuit électronique de gestion (non représenté) est de préférence un microcontrôleur pour application horlogère de type connu. Conformément à l'invention toujours, le dispositif de détection capacitif comprend un rotor solidaire en rotation du mobile, un stator, et un circuit électronique de mesure. Dans le présent exemple, la roue 4 est une roue en métal qui est reliée électriquement à la masse. Cette caractéristique permet à la roue 4 et à l'arbre 10 sur lequel elle est montée de remplir ensemble la fonction de rotor, c'est-à-dire la partie en rotation, pour le dispositif de détection capacitif. On comprendra donc que, dans le présent exemple, un seul et même mobile remplit simultanément les fonctions de mobile rotatif et de rotor du dispositif de détection.

La figure 1 montre que le stator comporte deux paires d'électrodes respectivement référencées 18a,18b et 20a,20b. Ces électrodes sont dessinées sur une carte de circuit imprimé (PCB) 22 qui est solidaire de la platine du mouvement 2. Dans le présent exemple, chaque paire d'électrodes (18a, 18b et 20a, 20b) est constituée de deux rubans conducteurs rectilignes qui sont formés sur le PCB 22 parallèlement l'un à l'autre. On peut voir que les deux paires d'électrodes s'étendent radialement sous la planche de la roue 4, et qu'elles font entre elles un angle d'environ 60°. On peut d'ailleurs vérifier que dans le mode de réalisation illustré les deux paires d'électrodes sont isométriques l'une à l'autre, c'est-à-dire de valeurs égales en norme pour une influence identique du rotor, et qu'elles sont de plus superposables par une rotation autour de l'axe 12. Un avantage de cette caractéristique est, qu'en l'absence d'effets parasites, les moyennes des capacités C1 et C2 sur une révolution complète du rotor sont égales, et en l'absence d'influence du rotor sur chacune des capacités C1 et C2, leur différence C1-C2 est nulle. On peut voir encore sur la figure 1 que le PCB porte une piste conductrice 24 qui relie les électrodes 18b et 20b entre elles, ainsi qu'à une borne de connexion 26c. Les électrodes 18a et 20a sont quant à elles reliées respectivement à des bornes de connexion 26a et 26b. Comme le montre la figure 1, les deux conducteurs formant les électrodes de chaque paire s'étendent parallèlement et à faible distance l'un de l'autre. En raison de la proximité entre les deux conducteurs, chaque paire d'électrodes se comporte comme un condensateur ayant une certaine capacité (la capacité de la première paire d'électrodes 18a, 18b est désignée par C1 et la capacité de la deuxième paire d'électrodes 20a, 20b est désignée par C2). En se référant simultanément aux figures 1 et 2, on peut remarquer encore que les paires d'électrodes 18a, 18, et 20a, 20b sont agencées relativement à la planche 8 de la roue 4 de manière à ce que l'entrefer qui sépare les électrodes de chacune des paires se trouve au moins partiellement au-dessous de l'ouverture 16 dans au moins une position angulaire de la roue 4. Qui plus est, les paires d'électrodes sont de préférence agencées de manière à ce que les deux électrodes d'une paire se trouvent simultanément au moins partiellement au-dessous de l'ouverture 16 dans au moins une position de la roue 4. On peut préciser de plus que la largeur d'entrefer d'une des paires d'électrodes est de préférence environ égale à la distance séparant en hauteur le PCB 22 de la planche 8 de la roue dentée.

Conformément à l'invention, le rotor du dispositif de détection capacitif 2 (autrement dit, la roue 4 ainsi que, à titre subsidiaire si cette pièce est également en métal, l'arbre 10) est conformé de manière à ce que la première capacité C1 et la deuxième capacité C2 dépendent toutes les deux de la position angulaire du rotor. Dans le mode de réalisation représenté, c'est la présence de l'ouverture 16 dans la planche 8 de la roue 4 qui rend les capacités C1 et C2 sensibles à la position angulaire du rotor. On comprendra que la capacité d'une paire d'électrodes est maximum quand l'ouverture 16 se trouve juste au-dessus de la paire d'électrodes, le transfert des charges de l'une à l'autre n'étant plus facilité par la présence d'un conducteur. On notera toutefois que le PCB 22 pourrait, de manière équivalente, être disposé au-dessus de la roue 4. On comprendra que dans une telle éventualité, les capacités atteindraient leur maximum lorsque l'ouverture 16 se trouve juste au-dessous d'une paire d'électrodes.

La figure 3 est un schéma électronique d'un circuit électronique de mesure apte à être utilisé dans le dispositif de détection capacitif des figures 1 et 2. Le principe de fonctionnement du circuit électronique représenté est de mettre sous tension les électrodes 18a et 20a par l'intermédiaire des bornes de connexion 26a, 26b, et de mesurer la quantité de charge qui, en réponse à cette mise sous tension, vient s'accumuler dans les électrodes 18b et 20b qui sont mutuellement reliées à la borne 26c commune.

Le circuit électronique qui est désigné globalement par la référence 28 sur la figure 3 est prévu pour se trouver dans deux modes de fonctionnement distincts. Un mode de fonctionnement assurant la mise à zéro (désigné par S0) et un mode de de fonctionnement correspondant à la mesure (désigné par S1). La commutation entre le deux modes de fonctionnement est commandée par le circuit électronique de gestion (non représenté) qui est agencé pour envoyer des signaux de commande à un certain nombre de commutateurs représentés par l'une des indications S0 ou S1 sur la figure 3. Les indications S0 ou S1 correspondent au mode de fonctionnement dans lequel les commutateurs sont fermés. Précisons que les commutateurs sont de préférence constitués par des transistors d'un circuit intégré dans lequel le circuit électronique de mesure est implémenté.

En se référant toujours à la figure 3, on peut voir que dans le mode de fonctionnement S0 toutes les électrodes 18a, 20a, 18b et 20b sont mises à la terre (VC). De plus, l'entrée non inverseuse (entrée +) de l'amplificateur 15 est également reliée à la terre, alors que la sortie de l'amplificateur 15 est court-circuitée avec son entrée inverseuse. Dans ces conditions, le courant et la tension sont partout nuls dans le circuit. Lorsque le circuit électronique est ensuite commuté dans le mode de fonctionnement S1, tous les commutateurs référencés S0 sont ouverts et les trois commutateurs référencés S1 sont fermés. Dans ces conditions, les électrodes 18a et 20a sont mises sous tension et placées respectivement aux potentiels de référence VP et VN. Les deux électrodes couplées 18b, 20b quant à elles sont reliées ensemble à l'entrée inverseuse de l'amplificateur 15. On peut voir encore sur la figure qu'il n'y a plus de court-circuit entre la sortie de l'amplificateur 15 et son entrée inverseuse. La sortie de l'amplificateur est maintenant reliée à l'entrée inverseuse par l'intermédiaire d'un condensateur référencé C13. On comprendra que, sous l'effet de la mise sous tension des électrodes 18a et 20a, les électrodes couplées 18b et 20b vont échanger des charges. De plus, dans le cas où les valeurs de C1 et C2 ne sont pas égales, le circuit électronique devra fournir aux électrodes couplées un solde de charges. Ce solde sera formé de charges négatives dans le cas où la capacité C1 est plus grande que la capacité C2, et de charges positives dans le cas où la capacité C1 est plus petite que la capacité C2. La tension qui est responsable du déplacement des charges de, ou vers, les deux électrodes couplées 18b 20b, va également produire une différence de potentiel entre les deux entrées de l'amplificateur 15. L'amplificateur 15 va donc émettre du courant tant que subsistera cette différence de potentiel. L'amplificateur va donc charger le condensateur C13 jusqu'à ce que la tension entre les deux entrées de l'amplificateur soit à nouveau nulle. A ce moment-là, la tension VM entre les bornes du condensateur C13 sera déterminée par la relation suivante :

$$VM = \frac{C1 - C2}{C13}\,(VP - VC)$$

On comprendra de plus que la tension entre les bornes du condensateur C13 est égale à l'amplitude du signal en sortie de l'amplificateur 15. Autrement dit, la tension VM correspond à la valeur du signal en sortie du circuit électronique de mesure. On peut noter en outre que, dans le cas où les moyennes des capacités C1 et C2 sur une révolution complète du rotor sont égales, la moyenne de la valeur du signal de sortie (*VM*) sur une révolution complète est égale à zéro.

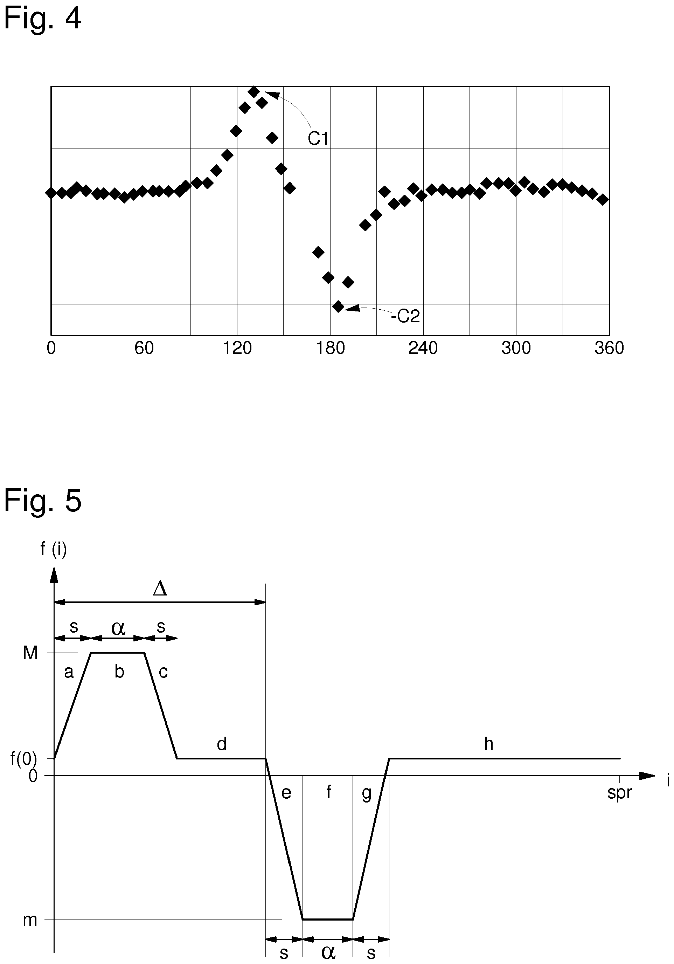

La figure 4 est graphique montrant à titre d'exemple les valeurs prises par le signal en sortie de l'amplificateur 15 lors de 60 mesures successives espacées de 6° en 6° et correspondant à une rotation de 360° de la roue 4. On a vu plus haut que la capacité d'une paire d'électrodes donnée est maximum quand l'ouverture 16 se trouve juste au-dessus de cette paire d'électrodes. Comme on peut le vérifier sur la figure 4, ce phénomène rend compte de la forme générale de la courbe. En effet, lorsque l'ouverture 16 passe au-dessus des électrodes 18a, 18b, la capacité C1 atteint un maximum qui se traduit par un premier pic positif de la courbe, Ensuite, lorsque l'ouverture passe au-dessus des électrodes 20a, 20b on observe un pic négatif dû à l'augmentation de la capacité C2. On notera que l'allure de la courbe peut varier considérablement d'un mode de réalisation à l'autre. En particulier, la forme des deux pics dépend de la forme et des dimensions de l'ouverture 16. D'autre part, l'allure de la courbe, entre les deux pics notamment, dépend dans une large mesure de l'agencement des deux paires d'électrodes 18a, 18b, 20a, 20b sur le PCB, qui sont ici de préférence espacées, selon le mode de réalisation préférentiel de la figure 1, de 60 degrés, soit la valeur angulaire entre le maximum et le minimum de la courbe de la figure 4. On peut par ailleurs déduire de la figure 4 que l'angle de référence « 0 » correspond à la position de l'aiguille sur la figure 1, à 9 heures selon la dénomination usuelle horlogère en rapport à la position des aiguilles sur un cadran.

Conformément à l'invention, les moyens électroniques de gestion contiennent un enregistrement d'une table associant une partie au moins des positions angulaires équidistantes les unes des autres occupées successivement par le mobile à autant de valeurs de référence du signal. La mémoire dans laquelle sont enregistrés les couples de valeurs constituant la table est de préférence une mémoire non-volatile. On comprendra que, grâce à l'utilisation d'une mémoire non-volatile, il est possible de se dispenser de recalibrer la position angulaire du mobile lorsqu'on rétablit l'alimentation électrique après une interruption (due par exemple au remplacement des piles). Dans ces conditions, la détermination des valeurs de référence calibrées et l'enregistrement de celles-ci dans la table est de préférence réalisée une fois pour toute en usine.

La façon la plus simple de réaliser un enregistrement d'une table associant chacune des positions angulaires équidistantes les unes des autres occupées successivement par le mobile à autant de valeurs de référence du signal est de commencer par initialiser simultanément la position angulaire du mobile et le circuit de comptage des impulsions de commande du moteur pas-à-pas, puis de faire effectuer un tour complet au mobile. Après chaque pas moteur durant ce tour complet, le circuit de comptage des impulsions fournit la valeur de la nouvelle position angulaire du mobile, et le circuit électronique de mesure fournit simultanément la valeur correspondante du signal différentiel. Une fois enregistrées dans une table de correspondance, la suite des paires de valeurs obtenues à chaque pas-moteur constituent une modélisation particulièrement simple du signal. Contrairement aux valeurs du signal réel, les valeurs de référence du signal peuvent être considérées comme se répétant à l'identique à chaque tour du mobile. La suite des valeurs de référence du signal peut donc avantageusement correspondre à une fonction périodique, la longueur de la période de cette fonction étant égale au nombre de pas-moteur nécessaires pour faire accomplir une révolution complète au rotor. La table de correspondance enregistrée n'a donc pas besoin de contenir plus d'une valeur de référence pour chaque position angulaire distincte du rotor, et la table de correspondance peut avantageusement avoir une structure en boucle traduisant la périodicité des valeurs de référence du signal. On comprendra que la périodicité des valeurs de référence est le reflet du caractère cyclique de la succession des positions angulaires occupées par le rotor, et dont la résolution angulaire correspond à celle définie par le moteur pas-à-pas.

La fonction du dispositif de détection capacitif de l'appareil électromécanique de la présente invention est de permettre la détection la position angulaire du mobile rotatif (constitué dans le présent exemple par le rotor, formé par la roue 4 dentée et l'arbre 10). Selon l'invention, pour détecter la position du mobile, le circuit électronique de gestion met en oeuvre un procédé consistant dans une première étape à commander le moteur pas-à-pas de manière à faire effectuer pas-à-pas une révolution complète au mobile, et à enregistrer les valeurs du signal fourni par le circuit électronique de mesure pour au moins une sur deux des dites positions angulaires mutuellement équidistantes les unes des autres du mobile.

Au cours d'une deuxième étape, le circuit électronique de gestion calcule la corrélation entre la succession des valeurs du signal enregistrées durant la première étape, et la succession des valeurs de référence tirées de la table, puis, mettant à profit la périodicité du signal de référence enregistré, le circuit électronique de gestion répète le calcul de corrélation en décalant chaque fois d'un pas supplémentaire le point de départ de la succession des valeurs de référence. Le circuit électronique de gestion effectue le calcul de corrélation autant de fois qu'il y a de position angulaire distincte pouvant constituer le point de départ d'une période de la fonction formée par les valeurs de référence.

Au cours d'une troisième étape, le circuit électronique de gestion détermine parmi les corrélations calculées au cours de la deuxième étape, celle dont la valeur est la plus élevée et identifie le point de départ de la période du signal de référence associée à cette corrélation. On comprendra que le point de départ ainsi identifié correspond à la position angulaire du mobile. En effet, le point de départ à partir duquel le tour complet est effectué durant la première étape doit être le même que le point de départ de la succession des valeurs de référence.

On a déjà exposé plus haut une manière particulièrement simple de réaliser une table de correspondance contenant des valeurs de référence calibrées du signal en sortie du circuit électronique de mesure. En se référant maintenant aux figures 5, et 6, on va décrire à titre d'exemple une deuxième manière possible de fabriquer une table de correspondance qui contient des valeurs de référence pour le signal calibrées en fonction de la position angulaire de la roue 4. La figure 5 et la table 1 ci-dessous représentent respectivement sous forme graphique et sous forme de formules un modèle linéaire par morceaux représentant le signal différentiel fourni par le circuit électronique de mesure en fonction d'un numéro de pas « $i$ » correspondant à une position angulaire donnée du mobile, tandis que la table 2 ci-après explique les différents paramètres qui sont utilisés pour déterminer ces valeurs de référence.

Table 1

| | | |
|---|---|---|
| ⓐ | $i \in [0,s]$ | $f(i) = \dfrac{M-f(0)}{s}i + f(0)$ |
| ⓑ | $i \in [s,s+\alpha]$ | $f(i) = M$ |
| ⓒ | $i \in [s+\alpha, 2s+\alpha]$ | $f(i) = \dfrac{M-f(0)}{s}(s+\alpha-i) + M$ |
| ⓓ | $i \in [2s+\alpha, \Delta]$ | $f(i) = f(0)$ |

(suite)

| | | |
|---|---|---|
| ⓔ | $i \in [\Delta, \Delta + s]$ | $f(i) = \frac{m - f(0)}{s}(i - \Delta) + f(0)$ |
| ⓕ | $i \in [\Delta + s, \Delta + s + \alpha]$ | $f(i) = m$ |
| ⓖ | $i \in [\Delta + s + \alpha, \Delta + 2s + \alpha]$ | $f(i) = \frac{m - f(0)}{s}(\Delta + s + \alpha - i) + m$ |
| ⓗ | $i \in [\Delta + 2s + \alpha, spr]$ | $f(i) = f(0)$ |

Table 2

$\mathcal{M}$ : = *valeur maximum de l'amplitude du signal;*

*m : = valeur minimum de l'amptitude du signal;*

*spr: = nombre de pas par tour = nombre de valeurs mesurées;*

*moy := valeur moyenne des mesures de l'amplitude du signal;*

$\alpha$ *:= largeur de l'éventuel plateau qui coupe la pointe du triangle (en nb. de pas);*

*s := distance horizontale entre la base et le plateau du triangle (en nb. de pas);*

*f (0) : = amplitude théorique du signal loin de l'ouverture (cette valeur est définie de manière à ce que la moyenne des vafeurs théoriques du signal de sortie soit égale à la moyenne des valeurs mesurées).*

Comme le montrent les formules de la table 1, le modèle du présent exemple est un modèle paramétrique dont les différents paramètres M, m, moy, $\alpha$, $\Delta$, s doivent être ajustés (fittés) de manière à ce que les valeurs de référence fournies par le modèle approximent le mieux possible les valeurs typiques d'une courbe empirique. Comme le montre la figure 5, qui montre l'amplitude du signal f(i) en fonction du nombre de pas « *i* » le modèle qui fait l'objet du présent exemple est constitué par un enchaînement de segments rectilignes. L'avantage principal d'avoir recours à un modèle linéaire par morceaux est que la caractéristique de linéarité simplifie les calculs nécessaires pour ajuster les paramètres.

Comme on peut encore le voir sur la figure 5, le modèle comprend 4 régions bien distinctes. Une première région comprenant les segments *a*, *b*, et *c* correspond à un pic positif associé au passage de l'ouverture 16 au-dessus de la paire d'électrodes 18a, 18b. Une deuxième région constituée par un segment horizontal *d* correspond au passage de l'ouverture au-dessus de la zone de la planche 8 qui s'étend entre les deux paires d'électrodes. Une troisième région comprenant les segments *e*, *f* et *g* correspond à un pic négatif associé au passage de l'ouverture au-dessus de la paire d'électrodes 20a, 20b, et enfin une quatrième région constituée par un long segment horizontal *h* correspond au passage de l'ouverture 16 de la roue 4 au-dessus du côté de la partie du PCB dépourvu d'électrodes. On comprendra que les valeurs prises par les différents paramètres du modèle déterminent la forme et la hauteur des pics, l'entendue des intervalles entre les pics, la valeur moyenne théorique, etc.

L'ajustement des différents paramètres du modèle peut se faire par exemple au moyen d'un calcul de régression multiple. Comme le modèle du présent exemple est linéaire, le calcul de régression peut consister en une simple régression multilinéaire. Le calcul de régression permettant de déterminer les valeurs des paramètres pour lesquelles l'écart vertical (en ordonnée) entre une courbe empirique fournie par le dispositif de détection capacitif et la courbe de référence issue du modèle paramétrique est minimum.

Conformément au présent exemple, une fois ajusté à la courbe empirique de la figure 4, le modèle paramétrique prend la forme de la courbe de référence représentée par la figure 6, qui montre similairement l'amplitude du signal f(i) en fonction du nombre de pas « *i* ». En comparant la courbe de la figure 6 à celle de la figure 5, on peut comprendre notamment que l'ajustement du modèle a conduit dans ce cas particulier à ce que le paramètre $\alpha$=0 et que le paramètre $\Delta$=2s. Une fois tous les paramètres ajustés, le circuit électronique de gestion enregistre les valeurs de la courbe de référence obtenues en mémoire sous la forme d'une table associant les différentes positions angulaires du mobile à la valeur de référence correspondante.

On pourra noter que la plupart des algorithmes pour le calcul d'une corrélation sont en mesure de fournir un résultat même lorsqu'il manque une partie des données parmi l'ensemble des valeurs à corréler. Dès lors, même si l'opération de calibration initiale ne fournit pas de valeurs de référence pour l'intégralité des positions angulaires possibles, l'opération de corrélation pourra toujours être effectuée ultérieurement et déterminer efficacement la position angulaire du mobile. L'avantage d'utiliser un modèle paramétrique pour déterminer les valeurs de référence est néanmoins précisément d'extrapoler des valeurs éventuellement manquantes par approximation linéaire. On peut ensuite extraire un sous-ensemble prédéterminé de valeurs de référence pour effectuer le calcul de corrélation, par exemple la moitié en tenant compte de la polarité du rotor, comme expliqué plus loin, pour augmenter la vitesse de calcul.

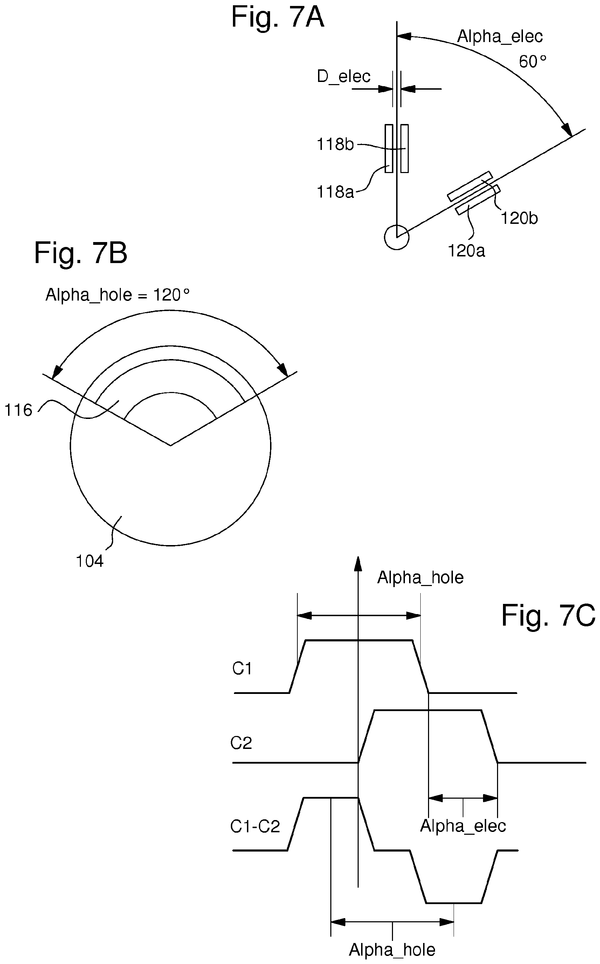

On va maintenant décrire un deuxième mode de réalisation de l'invention en faisant référence aux figures 7A, 7B et 7C. Le deuxième mode de réalisation se distingue du premier essentiellement par la forme et les dimensions de l'ouverture schématique 16 pratiquée dans la roue schématique 104 du rotor. Comme le montre la figure 7B, l'ouverture schématique 116 a la forme d'un secteur d'anneau référencé Alpha_hole dont l'ouverture vaut approximativement un tiers de tour (120°). Le stator du deuxième mode de réalisation du dispositif de détection capacitif est tout à fait semblable à celui qui a déjà été décrit en relation avec le premier mode de réalisation. On peut voir en particulier sur la figure 7A que les deux paires d'électrodes schématiques 118a, 118b, 120a, 120b sont dimensionnées de manière à pouvoir passer directement en regard de l'ouverture schématique 116, et qu'elles font entre elles un angle référencé Alpha_elec toujours d'environ 60°.

Du fait que le secteur d'anneau qui délimite l'ouverture pratiquée dans le rotor s'étend sur un angle considérablement plus grand que l'angle séparant les deux paires d'électrodes - deux fois selon l'exemple illustré - l'ouverture schématique 116 peut se trouver simultanément en regard des deux paires d'électrodes (cf. figure 7C), ce qui n'est jamais le cas dans le mode de réalisation préférentiel de la figure 1 où le secteur angulaire couvert par l'ouverture est beaucoup plus petit que l'écart angulaire entre les électrodes. On comprendra ainsi de ce qui précède que conformément à l'invention, l'angle définissant la largeur de l'ouverture dans le rotor peut être aussi bien plus grande que plus petite que l'angle qui sépare les deux paires d'électrodes. On précisera toutefois que même si l'ouverture est plus petite que la distance entre les deux paires d'électrodes, l'ouverture est toujours au moins aussi grande que la distance séparant les deux électrodes d'une même paire, matérialisée par la référence D_elec sur la figure 7A, de telle sorte qu'on ait toujours la présence d'un pic marqué pour les maxima des valeurs de chaque capacité C1 et C2. Par ailleurs, on pourra noter que cette distance inter-électrodes D_Elec, qui peut être réglée assez finement par paramétrage laser, devra être de préférence configurée pour être systématiquement supérieure ou égale à l'ébat en hauteur entre le PCB et la roue du rotor, de telle sorte que l'influence de l'ouverture pratiquée dans le rotor soit la plus grande possible vis-à-vis des capacités mesurées.

L'avantage du mode de réalisation illustré par les figures 7A, 7B et 7C est de fournir un gain massique de près de 30% de la roue du rotor, ce qui est avantageux en termes d'inertie et permet donc une mise en oeuvre plus facile du moteur pas-à-pas, procurant ainsi des économies d'énergie. Dans ce cas, on pourra également par exemple augmenter parallèlement la taille - et par conséquent le volume! - d'une aiguille, disposée au milieu du secteur Alpha_hole pour des raisons de symétrie, sans préjudice d'un déséquilibrage du système tournant, tout en améliorant la lisibilité de l'affichage.

Au vu des différents modes de réalisation décrits, on comprendra que différents types d'ouvertures sont possibles, non limités à des fentes. Des évidements de type « parts de gâteau » s'étendant jusqu'au centre du mobile sont également envisageables, permettant de diminuer encore plus la masse et donc l'inertie du rotor.

Selon un mode de réalisation avantageux de l'invention, le moteur pas-à-pas est un moteur bipolaire qui est prévu pour être alimenté par des impulsions de commande dont la polarité doit s'inverser à chaque pas pour faire fonctionner le moteur dans un sens déterminé. De tels moteurs bipolaires sont connus de l'homme du métier. Le document de brevet EP0341582 notamment décrit un tel moteur bipolaire qui est prévu pour pouvoir tourner pas-à-pas dans les deux sens, et qui doit recevoir en alternance des impulsions de commande polarisées dans un sens puis dans l'autre pour conserver un sens donné de rotation. On comprendra donc que lorsqu'un tel moteur fait accomplir pas-à-pas un tour complet à la roue 4, les pas successifs peuvent être répartis en deux catégories. La première catégorie est constituée des pas impairs (le 1er pas, le 3ème pas, le 5ème pas, etc.), et la seconde catégorie est constituée des pas pairs (le 2ème pas, le 4ème pas, etc.). Les pas impairs sont produits par une impulsion de commande polarisée dans un premier sens et les pas pairs sont produits par une impulsion de commande polarisée dans l'autre sens.

La possibilité qui vient d'être mentionnée de distinguer les pas-moteur pairs des pas-moteur impairs est avantageuse lorsque le nombre entier déterminé de pas-moteur nécessaires pour faire effectuer exactement un tour complet à la roue 4 est un nombre pair. En effet, dans ce cas, il est possible de distinguer parmi les positions angulaires qu'occupe successivement la roue 4 une moitié de positions angulaires atteintes suite à un pas-moteur pair et une autre moitié de positions angulaires atteintes suite à un pas-moteur impair. Selon une variante avantageuse, la table de correspondance qui est enregistrée dans le circuit électronique de gestion contient, en plus des valeurs de référence pour le signal en fonction de la position angulaire rotor, une indication de parité (paire ou impaire) pour chaque position angulaire du rotor selon qu'il faut un pas-moteur pair ou un pas-moteur impair pour atteindre la position angulaire en question. Grâce aux caractéristiques de la table de correspondance qui viennent d'être décrites, le procédé de détection de la position peut être simplifié. En effet, on comprendra que le nombre de corrélation à calculer peut être divisé par deux.

On comprendra en outre que diverses modifications et/ou améliorations évidentes pour un homme du métier peuvent être apportées aux modes de réalisation qui font l'objet de la présente description sans sortir du cadre de la présente invention définie par les revendications annexées.

**Revendications**

1. Appareil électromécanique comportant un mobile et un organe indicateur analogique (14) solidaires en rotation, un moteur pas-à-pas, un circuit électronique de gestion agencé pour commander le moteur pas-à-pas, une transmission reliant le moteur pas-à-pas au mobile et à l'organe indicateur analogique (14), et un dispositif de détection capacitif (2), la transmission ayant un rapport tel que le moteur pas-à-pas fasse accomplir exactement un tour complet au mobile en un nombre entier déterminé de pas-moteur, de sorte que les pas-moteurs subdivisent un tour complet du mobile en ledit nombre entier de positions angulaires mutuellement équidistantes les unes des autres, et le dispositif de détection capacitif (2) comprenant un rotor (4; 10) solidaire en rotation du mobile, un stator (18a, 18b, 20a, 20b, 22, 24, 26a, 26b, 26c), et un circuit électronique de mesure (28), le stator comportant une première paire d'électrodes (18a, 18b) ayant une première capacité (C1), le rotor (4;10) étant conformé de manière à ce que la valeur de la première capacité (C1) dépende de la position angulaire dudit rotor (4;10), et le circuit électronique de mesure (28) étant prévu pour générer et pour fournir au circuit électronique de gestion un signal dépendant de la valeur de la première capacité (C1); **caractérisé en ce que** le stator (18a ; 18b ; 20a ; 20b ; 22 ; 24 ; 26a ; 26b ; 26c) comporte une deuxième paire d'électrodes (20a, 20b) ayant une deuxième capacité (C2), la valeur de la deuxième capacité (C2) dépendant de la position angulaire dudit rotor (4;10), **en ce que** les paires d'électrodes (18a, 18b ; 20a, 20b) et le circuit électronique de mesure (28) sont configurés de manière à ce que le signal soit représentatif d'une différence entre les valeurs respectives de la première (C1) et de la deuxième capacité (C2), et **en ce que** les moyens électroniques de gestion contiennent un enregistrement d'une table de correspondance qui contient des valeurs de référence pour le signal en fonction de la position angulaire du rotor (4;10) pour lesdites positions angulaires mutuellement équidistantes les unes des autres du mobile.

2. Appareil électromécanique selon la revendication 1, **caractérisé en ce que** le circuit électronique de gestion comprend un circuit de comptage des impulsions de commande du moteur pas-à-pas, de manière à compter les pas effectués par le moteur pas-à-pas.

3. Appareil électromécanique selon la revendication 2, **caractérisé en ce que** le moteur pas-à-pas est un moteur bipolaire prévu pour être alimenté par des impulsions de courant dont le sens de circulation doit s'inverser à chaque pas pour faire fonctionner le moteur dans un sens déterminé, et **en ce que** la table de correspondance qui est enregistrée dans le circuit électronique de gestion contient, en plus des valeurs de référence pour le signal en fonction de la position angulaire dudit rotor (4;10), une indication de parité (paire ou impaire) pour chaque position angulaire dudit rotor (4;10), selon qu'il faut un pas-moteur pair ou un pas-moteur impair pour atteindre la position angulaire en question.

4. Appareil électromécanique selon l'une des revendications précédentes, **caractérisé en ce que** le rotor (4;10) du dispositif de détection capacitif (2) comporte une roue (4) réalisée en un matériau conducteur et dont la planche (8) est percée d'une ouverture (16) de forme et de dimensions déterminées, le dispositif de détection capacitif étant agencé de manière à ce qu'une électrode de la première paire (18a, 18b) et une électrode de la deuxième paire (20a, 20b) soient au moins partiellement en regard de ladite ouverture (16) respectivement dans une première et une deuxième position angulaire dudit rotor (4;10).

5. Appareil électromécanique selon l'une des revendications précédente, **caractérisé en ce que** les électrodes (18a, 18b ; 20a, 20b) de la première et la deuxième paire s'étendent dans un même plan perpendiculaire à l'axe (12) dudit rotor (4;10).

6. Appareil électromécanique selon la revendication 5, **caractérisé en ce que** les deux paires d'électrodes (18a, 18b ; 20a, 20b) sont isométriques l'une à l'autre, et superposables par rotation d'une des deux paires autour de l'axe 12.

7. Appareil électromécanique selon l'une des revendications précédentes, **caractérisé en ce que** le stator (18a ; 18b ; 20a ; 20b ; 22 ; 24 ; 26a ; 26b ; 26c) du dispositif de détection capacitif (2) comprend un conducteur (24) qui relie une (18b) des électrodes de la première paire à une (20b) des électrodes de la deuxième paire.

8. Appareil électromécanique selon l'une des revendications précédentes, caractérisé en ce quer l'organe indicateur analogique (14) est une aiguille.

9. Appareil électromécanique selon la revendication 8, **caractérisé en ce que** l'aiguille est solidaire du rotor (4;10), l'aiguille pointant en direction du centre de l'ouverture (16) de façon à ce que le balourd engendré par la présence de l'ouverture permette de compenser au moins partiellement le couple provoqué par le poids de l'aiguille.

**10.** Appareil électromécanique selon l'une des revendications précédentes, **caractérisé en ce que** la table de correspondance qui contient les valeurs de référence pour le signal en fonction de la position angulaire dudit rotor (4;10) est enregistrée dans une mémoire non-volatile du circuit électronique de gestion.

**11.** Appareil électromécanique selon la revendication 9, **caractérisé en ce que** les valeurs de référence pour le signal définissent une fonction de la position angulaire dudit rotor (4;10), la fonction étant linéaire par morceau.

**12.** Procédé de détermination de la position angulaire d'un mobile solidaire en rotation d'un indicateur analogique (14) d'un appareil électromécanique conforme à l'une des revendications 1 à 11, le procédé comportant les étapes de:

I. commander le moteur pas-à-pas de manière à faire effectuer pas-à-pas une révolution complète à un rotor (4;10) solidaire en rotation dudit mobile, et enregistrer les valeurs du signal fourni par le circuit électronique de mesure (28) pour au moins une sur deux des dites positions angulaires mutuellement équidistantes les unes des autres dudit mobile;

II. tirer, de la table enregistrée faisant correspondre une partie au moins du nombre entier de positions angulaires équidistantes les unes des autres du mobile à autant de valeurs de référence du signal, une pluralité de suites de valeurs de référence correspondant respectivement aux différentes permutations circulaires possibles des dites au moins une position angulaire sur deux desdites positions angulaires équidistantes les unes des autres, et calculer une corrélation entre la succession des valeurs enregistrées du signal fourni et chacune des suites de valeurs de référence;

III. déterminer la position angulaire dudit indicateur analogique (14) en identifiant parmi les corrélations calculées pour les différentes suites de valeurs de référence, la corrélation dont la valeur est maximale.

**13.** Procédé de détermination de la position angulaire d'un mobile conforme à la revendication 12, **caractérisée en ce qu'**à l'étape (I), les valeurs du signal fourni par le circuit électronique de mesure (28) sont enregistrées pour toutes lesdites positions angulaires mutuellement équidistantes les unes des autres du mobile, et **en ce que**, à l'étape (II), le nombre de suites de valeurs de référence est égal au dit nombre déterminé, les suites correspondant respectivement aux différentes permutations circulaires de toutes lesdites positions angulaires équidistantes.

**14.** Procédé de détermination de la position angulaire d'un mobile conforme à la revendication 12, dans lequel le moteur pas-à-pas de l'appareil électromécanique est un moteur bipolaire prévu pour être alimenté par des impulsions de courant dont le sens de circulation doit s'inverser à chaque pas pour faire fonctionner le moteur dans un sens déterminé, le procédé étant **caractérisé en ce que** le dit nombre déterminé est un nombre pair, **en ce qu'**à l'étape (I), les valeurs du signal fourni par le circuit électronique de mesure (28) sont enregistrées pour une sur deux des positions angulaires mutuellement équidistantes les unes des autres du mobile, et **en ce que**, à l'étape (II), le nombre de suites de valeurs de référence est égal à la moitié du dit nombre déterminé, les suites correspondant respectivement aux différentes permutations circulaires des dites une sur deux des positions angulaires mutuellement équidistantes les unes des autres.

**Patentansprüche**

**1.** Elektromechanische Vorrichtung, umfassend ein Drehteil und ein analoges Anzeigeorgan (14), die drehfest miteinander verbunden sind, einen Schrittmotor, eine elektronische Steuerschaltung, die dafür ausgelegt ist, den Schrittmotor anzusteuern, ein Getriebe, das den Schrittmotor mit dem Drehteil und mit dem analogen Anzeigeorgan (14) verbindet, und eine kapazitive Detektionseinrichtung (2), wobei das Getriebe ein solches Übersetzungsverhältnis besitzt, dass der Schrittmotor bei einer festgelegten ganzzahligen Anzahl von Motorschritten genau eine vollständige Umdrehung des Drehteils bewirkt, derart, dass die Motorschritte eine vollständige Umdrehung des Drehteils in die ganzzahlige Anzahl von gleichmäßig voneinander beabstandeten Winkelpositionen unterteilen, und wobei die kapazitive Detektionseinrichtung (2) einen mit dem Drehteil drehfest verbundenen Rotor (4; 10), einen Stator (18a, 18b, 20a, 20b, 22, 24, 26a, 26b, 26c) und eine elektronische Messschaltung (28) umfasst, wobei der Stator ein erstes Paar Elektroden (18a, 18b) umfasst, die eine erste Kapazität (C1) aufweisen und der Rotor (4; 10) so ausgebildet ist, dass der Wert der ersten Kapazität (C1) von der Winkelposition des Rotors (4; 10) abhängt, und wobei die elektronische Messschaltung (28) dazu vorgesehen ist, ein von dem Wert der ersten Kapazität (C1) abhängiges Signal zu erzeugen und an die elektronische Steuerschaltung zu liefern; **dadurch gekennzeichnet, dass** der Stator (18a, 18b, 20a, 20b, 22, 24, 26a, 26b, 26c) ein zweites Paar Elektroden (20a, 20b) umfasst, die eine zweite Kapazität (C2) aufweisen, wobei der Wert der zweiten Kapazität (C2) von der Winkelposition des Rotors (4; 10) abhängt, dass die Elektrodenpaare (18a, 18b; 20a, 20b) und die elektronische Messschaltung (28) in einer Weise konfiguriert sind, dass das Signal eine Differenz zwischen den jeweiligen Werten der ersten (C1) und der zweiten (C2) Kapazität darstellt, und dass die elektronischen Steuermittel eine Aufzeichnung einer Korrespondenztabelle enthalten, die Referenzwerte für das Signal als Funktion der Winkelposition des Rotors (4; 10) für die gleichmäßig voneinander beabstandeten Winkelpositionen des Drehteils enthält.

**2.** Elektromechanische Vorrichtung nach Anspruch 1, **dadurch gekennzeichnet, dass** die elektronische Steuerschaltung eine Schaltung zum Zählen von Steuerimpulsen des Schrittmotors umfasst, um die von dem Schrittmotor ausgeführten Schritte zu zählen.

**3.** Elektromechanische Vorrichtung nach Anspruch 2, **dadurch gekennzeichnet, dass** der Schrittmotor ein bipolarer Motor ist, der dafür vorgesehen ist, durch die Stromimpulse versorgt zu werden, deren Laufrichtung sich bei jedem Schritt umzukehren hat, um den Motor in einer bestimmten Richtung arbeiten zu lassen, und dass die Korrespondenztabelle, die in der elektronischen Steuerschaltung aufgezeichnet ist, zusätzlich zu den Referenzwerten für das Signal als Funktion der Winkelposition des Rotors (4; 10) eine Paritätsangabe (gerade oder ungerade) für jede Winkelposition des Rotors (4; 10) enthält, je nachdem, ob er einen geradzahligen Motorschritt oder einen ungeradzahligen Motorschritt ausführt, um die betreffende Winkelposition zu erreichen.

**4.** Elektromechanische Vorrichtung nach einem der vorhergehenden Ansprüche, **dadurch gekennzeichnet, dass** der Rotor (4; 10) der kapazitiven Detektionsvorrichtung (2) ein Rad (4) umfasst, das aus einem leitenden Material hergestellt ist und dessen Radscheibe (8) von einer Öffnung (16) mit bestimmter Form und bestimmten Abmessungen durchbrochen ist, wobei die kapazitive Detektionseinrichtung dafür ausgelegt ist, dass sich eine Elektrode des ersten Paars (18a, 18b) und eine Elektrode des zweiten Paars (20a, 20b) jeweils entsprechend in einer ersten und einer zweiten Winkelposition des Rotors (4; 10) zumindest teilweise gegenüber der Öffnung (16) befinden.

**5.** Elektromechanische Vorrichtung nach einem der vorhergehenden Ansprüche, **dadurch gekennzeichnet, dass** sich die Elektroden (18a, 18b; 20a, 20b) des ersten und des zweiten Paars in derselben, zu der Achse (12) des Rotors (4; 10) senkrechten Ebene erstrecken.

**6.** Elektromechanische Vorrichtung nach Anspruch 5, **dadurch gekennzeichnet, dass** die beiden Elektrodenpaare (18a, 18b; 20a, 20b) zueinander isometrisch sind und durch Drehung eines der beiden Paare um die Achse (12) einander überlagerbar sind.

**7.** Elektromechanische Vorrichtung nach einem der vorhergehenden Ansprüche, **dadurch gekennzeichnet, dass** der Stator (18a, 18b, 20a, 20b, 22, 24, 26a, 26b, 26c) der kapazitiven Detektionseinrichtung (2) einen Leiter (24) aufweist, der eine (18b) der Elektroden des ersten Paars mit einer (20b) der Elektroden des zweiten Paars verbindet.

**8.** Elektromechanische Vorrichtung nach einem der vorhergehenden Ansprüche, **dadurch gekennzeichnet, dass** das analoge Anzeigeorgan (14) ein Zeiger ist.

**9.** Elektromechanische Vorrichtung nach Anspruch 8, **dadurch gekennzeichnet, dass** der Zeiger mit dem Rotor (4; 10) fest verbunden ist, wobei der Zeiger in Richtung der Mitte der Öffnung (16) zeigt, derart, dass die durch das Vorhandensein der Öffnung verursachte Unwucht ermöglicht, das durch das Gewicht des Zeigers hervorgerufene Drehmoment zumindest teilweise auszugleichen.

**10.** Elektromechanische Vorrichtung nach einem der vorhergehenden Ansprüche, **dadurch gekennzeichnet, dass** die Korrespondenztabelle, die die Referenzwerte für das Signal als Funktion der Winkelposition des Rotors (4; 10) enthält, in einem nichtflüchtigen Speicher der elektronischen Steuerschaltung aufgezeichnet ist.

**11.** Elektromechanische Vorrichtung nach Anspruch 9, **dadurch gekennzeichnet, dass** die Referenzwerte für das Signal eine Funktion der Winkelposition des Rotors (4; 10) definieren, wobei die Funktion stückweise linear ist.

**12.** Verfahren zum Bestimmen der Winkelposition eines mit einem analogen Anzeiger (14) einer elektromechanischen Vorrichtung nach einem der Ansprüche 1 bis 11 drehfest verbundenen Drehteils, wobei das Verfahren die folgenden Schritte umfasst:

I. Ansteuern des Schrittmotors in der Weise, dass schrittweise eine vollständige Umdrehung eines mit dem Drehteil drehfest verbundenen Rotors (4; 10) bewirkt wird, und Aufzeichnen der Werte des von der elektronischen Messschaltung (28) gelieferten Signals für mindestens eine von zwei der gleichmäßig voneinander beabstandeten Winkelpositionen des Drehteils;

II. Extrahieren aus der aufgezeichneten Tabelle, die eine Korrespondenz zwischen mindestens einem Teil der ganzzahligen Anzahl von gleichmäßig voneinander beabstandeten Winkelpositionen des Drehteils mit ebenso vielen Referenzwerten des Signals herstellt, mehrerer Folgen von Referenzwerten, die jeweils den verschiedenen möglichen zyklischen Permutationen der mindestens einen Winkelposition von zwei der gleichmäßig voneinander beabstandeten Winkelpositionen entsprechen, und Berechnen einer Korrelation zwischen der Folge aufgezeichneter Werte des gelieferten Signals und jeder der Folgen von Referenzwerten;

III. Bestimmen der Winkelposition des analogen Anzeigers (14) durch Identifizieren jener Korrelation unter den berechneten Korrelationen für die verschiedenen Folgen von Referenzwerten, deren Wert maximal ist.

**13.** Verfahren zum Bestimmen der Winkelposition eines Drehteils nach Anspruch 12, **dadurch gekennzeichnet, dass** im Schritt (I) die Werte des von der elektronischen Messschaltung (28) gelieferten Signals für alle Winkelpositionen des Drehteils, die gleichmäßig voneinander beabstandet sind, aufgezeichnet werden und dass im Schritt (II) die Anzahl von Folgen von Referenzwerten gleich der festgelegten Anzahl ist, wobei die Folgen jeweils den verschiedenen zyklischen Permutationen sämtlicher gleichmäßig beabstandeter Winkelpositionen entsprechen.

**14.** Verfahren zum Bestimmen der Winkelposition eines Drehteils nach Anspruch 12, wobei der Schrittmotor der elektromechanischen Vorrichtung ein bipolarer Motor ist, der dazu vorgesehen ist, durch die Stromimpulse versorgt zu werden, deren Laufrichtung sich bei jedem Schritt umzukehren hat, um den Motor in einer bestimmten Richtung arbeiten zu lassen, wobei das Verfahren **dadurch gekennzeichnet ist, dass** die festgelegte Anzahl eine geradzahlige Anzahl ist, dass im Schritt (I) die Werte des von der elektronischen Messschaltung (28) gelieferten Signals für eine von zwei der gleichmäßig voneinander beabstandeten Winkelpositionen des Drehteils aufgezeichnet werden und dass im Schritt (II) die Anzahl von Folgen von Referenzwerten gleich der Hälfte der festgelegten Anzahl ist, wobei die Folgen jeweils den verschiedenen zyklischen Permutationen der einen von zwei gleichmäßig voneinander beabstandeten Winkelpositionen entsprechen.

## Claims

**1.** Electromechanical apparatus comprising a wheel set and an analogue indicator member (14) which are integral in rotation, a stepping motor, an electronic control circuit arranged to control the stepping motor, a drive train connecting the stepping motor to the wheel set and to the analogue indicator member (14), and a capacitive detection device (2), the drive train having a ratio such that the stepping motor causes the wheel set to make exactly one complete revolution in a determined integer number of motor steps, so that the motor steps subdivide one complete revolution of the wheel set into said integer number of mutually equidistant angular positions, and the capacitive detection device (2) comprising a rotor (4; 10) integral in rotation with the wheel set, a stator (18a, 18b, 20a, 20b, 22, 24, 26a, 26b, 26c), and an electronic measuring circuit (28), the stator comprising a first pair of electrodes (18a, 18b) having a first capacitance (C1), the rotor (4; 10) being adapted such that the value of the first capacitance (C1) depends on the angular position of said rotor (4; 10), and the electronic measuring circuit (28) being arranged to generate and to provide to the electronic control circuit a signal dependent on the value of the first capacitance (C1);

**characterized in that** the stator (18a, 18b, 20a, 20b, 22, 24, 26a, 26b, 26c) includes a second pair of electrodes (20a, 20b) having a second capacitance (C2), the value of the second capacitance (C2) depending on the angular position of said rotor (4; 10), **in that** the pairs of electrodes (18a, 18b; 20a, 20b) and the electronic measuring circuit (28) are configured such that the signal is representative of a difference between the respective values of the first (C1) and of the second (C2) capacitance, and **in that** the electronic control means contain a stored correspondence table which contains reference values for the signal as a function of the angular position of the rotor (4; 10) for said mutually equidistant angular positions of the wheel set.

**2.** Electromechanical apparatus according to claim 1, **characterized in that** the electronic control circuit includes a circuit for counting the control impulses of the stepping motor, in order to count the steps made by the stepping motor.

**3.** Electromechanical apparatus according to claim 2, **characterized in that** the stepping motor is a bipolar motor arranged to be powered by current impulses whose flow direction must be inverted at each step in order to operate the motor in a determined direction, and **in that** the correspondence table which is stored in the electronic control circuit contains, in addition to the reference values for the signal as a function of the angular position of said rotor (4; 10), an indication of parity (even or odd) for each angular position of said rotor (4; 10), depending on whether an even motor step or an odd motor step is required to reach the angular position in question.

**EP 3 037 898 B1**

4. Electromechanical apparatus according to any of the preceding claims, **characterized in that** the rotor (4; 10) of the capacitive detection device (2) comprises a wheel (4) made of a conductive material and whose plate (8) is pierced with an opening (16) of determined shape and dimensions, the capacitive detection device being arranged so that one electrode of the first pair (18a, 18b) and one electrode of the second pair (20a, 20b) are at least partially opposite said opening (16) respectively in a first and a second angular position of said rotor (4; 10).

5. Electromechanical apparatus according to any of the preceding claims, **characterized in that** the electrodes (18a, 18b; 20a, 20b) of the first and of the second pair extend in the same plane perpendicular to the axis (12) of said rotor (4; 10).

6. Electromechanical apparatus according to claim 5, **characterized in that** the two pairs of electrodes (18a, 18b; 20a, 20b) are isometric to each other, and superposable by rotating one of the two pairs about the axis (12).

7. Electromechanical apparatus according to any of the preceding claims, **characterized in that** the stator (18a; 18b; 20a; 20b; 22; 24; 26a; 26b; 26c) of the capacitive detection device (2) comprises a conductor (24) that connects one (18b) of the electrodes of the first pair to one (20b) of the electrodes of the second pair.

8. Electromechanical apparatus according to any of the preceding claims, **characterized in that** the analogue indicator member (14) is a hand.

9. Electromechanical apparatus according to claim 8, **characterized in that** the hand is integral with the rotor (4; 10), the hand pointing in the direction of the centre of the opening (16) so that the unbalance caused by the presence of the opening can at least partially compensate for the torque caused by the weight of the hand.

10. Electromechanical apparatus according to any of the preceding claims, **characterized in that** the correspondence table which contains the reference values for the signal as a function of the angular position of said rotor (4; 10) is stored in a non-volatile memory of the electronic control circuit.

11. Electromechanical apparatus according to claim 9, **characterized in that** the reference values for the signal define a function of the angular position of said rotor (4; 10), the function being a piecewise linear function.

12. Method for determination of the angular position of a wheel set integral in rotation with an analogue indicator (14) of an electromechanical apparatus according to any of claims 1 to 11, the method including the steps of:

> I. controlling the stepping motor so as to cause a rotor (4; 10) integral with said wheel set to make one complete step-by-step revolution, and to store signal values provided by the electronic measuring circuit (28) for at least one in two of said mutually equidistant angular positions of said wheel set;
> II. drawing, from the stored table matching at least one part of the integer number of mutually equidistant angular positions of the wheel set to as many reference values of the signal, a plurality of sequences of reference values respectively corresponding to the various possible circular permutations of said at least one in two angular positions of said mutually equidistant angular positions, and calculating a correlation between the succession of stored values of the signal provided and each of the sequences of reference values;
> III. determining the angular position of said analogue indicator (14) by identifying among the correlations calculated for the various sequences of reference values, the correlation whose value is maximum.

13. Method for determination of the angular position of a wheel set according to claim 12, **characterized in that** in step (I), the values of the signal provided by the electronic measuring circuit (28) are stored for all said mutually equidistant angular positions of the wheel set, and **in that**, in step (II), the number of reference value sequences is equal to said determined number, the sequences respectively corresponding to the various circular permutations of all said equidistant angular positions.

14. Method for determination of the angular position of a wheel set according to claim 12, wherein the stepping motor of the electromechanical apparatus is a bipolar motor arranged to be powered by current impulses whose direction of flow must be inverted at each step in order to operate the motor in a determined direction, the method being **characterized in that** said determined number is an even number, **in that** in step (I), the values of the signal provided by the electronic measuring circuit (28) are stored for one in two of the mutually equidistant angular positions of the wheel set, and **in that**, in step (II), the number of reference value sequences is equal to half of said determined number, the sequences respectively corresponding to the various circular permutations of said one in two of the mutually equidistant angular positions.

14

## Fig. 1

## Fig. 2

# Fig. 3

=VP (ex. 5V)

=VN (ex. -5V)

$=VC = \dfrac{VP+VN}{2}$ (ex. 0V)

# Fig. 6

## Fig. 4

## Fig. 5

## Fig. 7A

Alpha_elec
60°

D_elec

118b

118a

120b

120a

## Fig. 7B

Alpha_hole = 120°

116

104

## Fig. 7C

Alpha_hole

C1

C2

C1-C2

Alpha_elec

Alpha_hole

Fig. 8
(Art antérieur)

## RÉFÉRENCES CITÉES DANS LA DESCRIPTION

### Documents brevets cités dans la description

- EP 0952426 A
- US 6307814 B
- JP 2004163128 B
- JP 2004233132 B
- EP 0952426 A1
- EP 0341582 A